# EUROPEAN PATENT APPLICATION

(11) **EP 1 973 173 A2**
(43) Date of publication of application: **24.09.2008**
(21) Application number: 08152962.0
(22) Date of filing: 18.03.2008
(51) Int. Cl.: H01L 31/18, H01L 31/05, B23K 1/00, B23K 3/08

(54) **Photovoltaic cell holder for holding a photovoltaic cell and interconnectors**

(30) Priority: 20.03.2007 JP 2007072697
(71) Applicant: Nisshinbo Industries, Inc., Nihonbashi Chuo-ku Tokyo 103-8650 (JP)
(72) Inventor: Katayama, Manabu, Okazaki Shi 444-8560 (JP); Ichimura, Hikaru, Okazaki Shi 444-8560 (JP)
(74) Representative: Jannig, Peter

(57) **Abstract**

A photovoltaic cell holder to hold a photovoltaic cell and interconnectors for soldering the interconnectors to top and bottom surfaces of the photovoltaic cell has an upper holder and a lower holder. The upper holder includes an upper retainer to press the interconnectors against the top surface of the cell. The upper retainer includes multiple elastic stick-shaped members and one or more flange parts provided at one end of the stick-shaped members. The lower holder includes one or more bar-shaped lower supports to support the interconnectors against the bottom surface of the cell. The lower supports extend parallel to the interconnectors, and a surface of each lower support that contacts the interconnectors has either a groove or a hole. The photovoltaic cell holder holds the interconnectors tightly over substantially all areas to provide uniform welding quality while allowing flux gas to escape to prevent the cell from bending during soldering.

## Description

### CLAIM FOR PRIORITY

The present specification claims priority from Japanese Patent Application No. 2007-072697, filed on March 20, 2007 in the Japan Patent Office, the entire contents of which are hereby incorporated by reference herein.

### BACKGROUND

### FIELD OF THE INVENTION

The present invention relates to a photovoltaic cell holder that holds a photovoltaic cell (hereinafter also referred to simply as a cell) and interconnectors when soldering the interconnectors to the photovoltaic cells that form a photovoltaic module during manufacture of photovoltaic module.

### DESCRIPTION OF THE BACKGROUND ART

JP-H11-87756-A and JP-2003-168811-A disclose an interconnector soldering technique in which, when interconnectors are positioned on and soldered to a photovoltaic cell, the interconnectors are pressed and supported against the cell by bar- or rod-shaped rigid press members and heated to melt the solder, after which the cell is cooled.

However, conventional interconnector soldering using press members has the following drawbacks.

First, in an arrangement in which the interconnectors to be mounted on top and bottom surfaces of a cell are pressed and supported by rod-shaped rigid press members, bending and warping of the cell during heating and cooling causes partial separation of the interconnectors from the cell. As a result, the strength of the weld is not uniform. Moreover, when the cell is held strongly enough to prevent it from deforming, the cell may be damaged.

Second, during soldering, the interconnectors sometimes weld to the press members and the photovoltaic cell cannot be separated from the press members.

Third, pressing and supporting the interconnectors at multiple places using a plurality of bars causes changes in thermal conditions between the held and the free sections of the interconnectors. This unevenness in thermal conditions can cause unevenness in welding.

Neither JP-H11-87756-A nor JP-2003-168811-A discloses a solution to the above-described drawbacks.

### SUMMARY

The present invention has as its object to obtain uniform welding quality between a photovoltaic cell and interconnectors without the interconnectors and the press members welding to each other during soldering of the interconnectors onto the photovoltaic cell by holding the interconnectors tightly over substantially all areas while at the same time allowing flux gas to escape.

To achieve the above-described object, the present invention provides a photovoltaic cell holder to hold both a photovoltaic cell and interconnectors in order to soldering the interconnectors to a top surface and a bottom surface of the photovoltaic cell. The photovoltaic cell holder includes an upper holder and a lower holder. The upper holder includes an upper retainer configured to press the interconnectors against the top surface of the photovoltaic cell. The upper retainer has a plurality of elastic stick-shaped members and one or more flange parts provided at one end of the stick-shaped members. The lower holder includes one or more bar-shaped lower supports configured to support the interconnectors against the bottom surface of the photovoltaic cell. The lower supports extend parallel to the interconnectors. A surface of each lower support that contacts the interconnectors has either a groove or a hole formed therein.

In addition, a tapered portion may be provided at each of both ends of the flange part of the upper retainer in a long direction of the interconnectors. The flange part of the upper retainer may be attached to a plurality of the stick-shaped members and has either a groove or a hole formed therein. A peel-off layer may be provided on either a contact portion of the upper retainer that contacts the interconnectors or a contact portion of the lower support that contacts the interconnectors.

The present invention provides at least one of the following effects.

First, using the lower support and the upper retainer of the present invention enables uneven welds and weld defects caused by contacting and holding the interconnectors uniformly with flanges or bars to be prevented.

Second, because the lower support and the upper retainer of the present invention are constructed so as to allow flux gas to escape, welding malfunctions in the form of the interconnectors being welded to the lower support or the upper retainer can be prevented.

Third, by providing a peel-off layer on the lower support and the upper retainer of the present invention, welding of the interconnectors to the lower support or the upper retainer can be prevented.

Other features and advantages of the present invention will be apparent from the following description when taken in conjunction with the accompanying drawings, in which like reference characters designate similar or identical parts throughout the several views thereof.

### BRIEF DESCRIPTION OF THE DRAWINGS

FIG. 1 shows a plan view of photovoltaic cells to which interconnectors are to be soldered;
FIG. 2 shows a sectional view of the photovoltaic cell shown in FIG. 1;
FIG. 3 shows a lateral sectional view showing schematically steps in implementing a soldering method;
FIGS. 4A and 4B show perspective views of a photovoltaic cell holder according to a first embodiment of the present invention;
FIG. 5 is a schematic diagram of the photovoltaic cell holder holding the photovoltaic cell and the interconnectors;
FIG. 6 shows a perspective view of a press bar and a flange part of an upper retainer according to a second embodiment of the present invention;
FIGS. 7A and 7B show perspective views of a lower support;
FIGS. 8A and 8B show perspective views of a press bar and a flange part of an upper retainer according to a third embodiment of the present invention; and
FIG. 9 shows a perspective view of a lower support according to the third embodiment of the present invention.

### DETAILED DESCRIPTION

A detailed description will now be given of illustrative embodiments of the present invention, with reference to the accompanying drawings. In so doing, specific terminology is employed solely for the sake of clarity, and the present disclosure is not to be limited to the specific terminology so selected. It is to be understood that each specific element includes all technical equivalents that operate in a similar manner and achieve a similar result.

### The Photovoltaic Cell

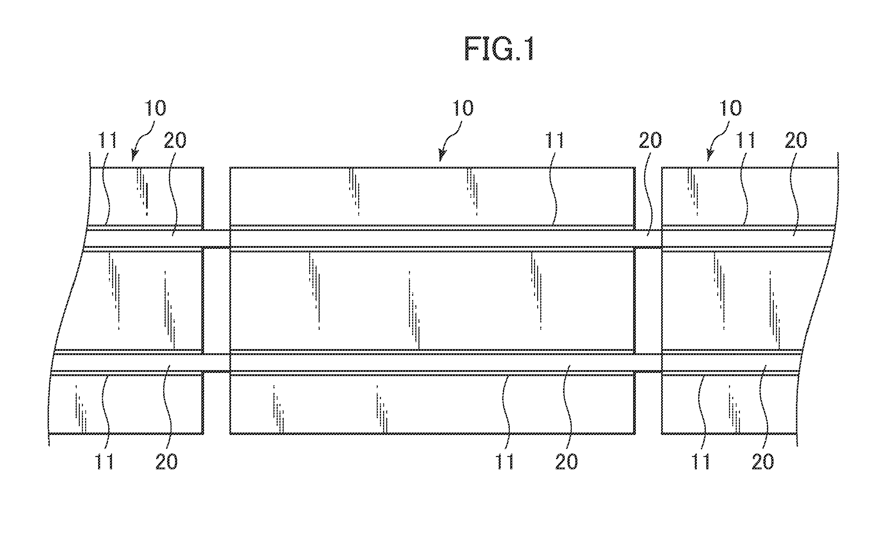

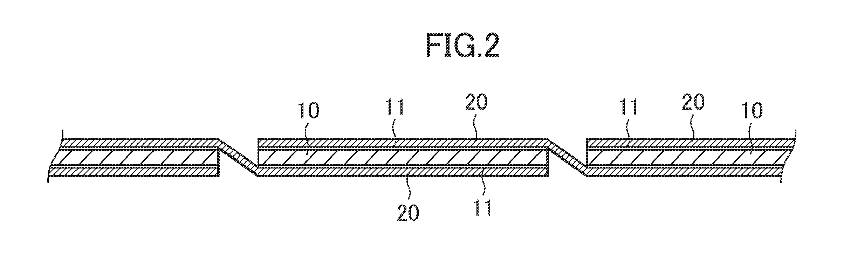

FIGS. 1 and 2 show photovoltaic cells 10 to which interconnectors 11 are to be soldered.

As shown in FIG. 1, two parallel rows of electrodes 11 are provided on the surfaces of the photovoltaic cell 10.

As shown in FIG. 2, positive electrodes 11 are provided on the top surface of the photovoltaic cell 10 and negative electrodes 11 are provided on the bottom surface of the photovoltaic cell 10. A plurality of photovoltaic cells 10 is aligned and the electrodes 11 on the top surfaces of adjacent photovoltaic cells 10 and the electrodes 11 on the bottom surfaces of adjacent photovoltaic cells 10 are connected in series by interconnectors 20

### The Soldering Method

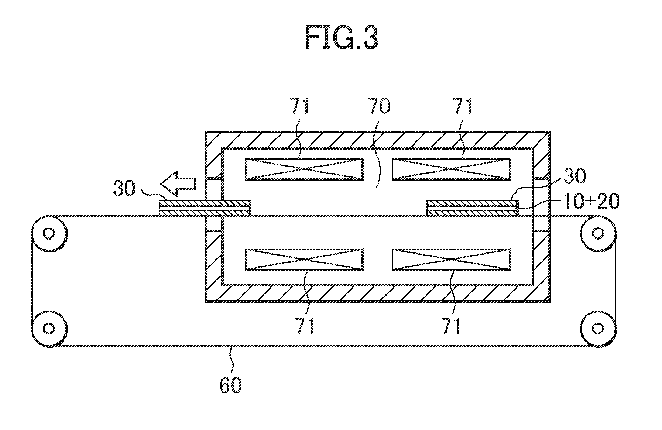

FIG. 3 shows a sectional view of the general structure of a soldering apparatus using a photovoltaic cell holder 30 according to the present invention. As shown in FIG. 1 and FIG. 2, when soldering a plurality of photovoltaic cells 10 and interconnectors 20, a necessary number of the holders 30 of the present invention are connected at constant intervals. For simplicity, a description is given of transporting a single holder 30 to a heating space 70 using a transport conveyer 60 when soldering.

In the soldering step, the photovoltaic cells 10 and the interconnectors 20 are positioned and held using the photovoltaic cell holder 30, with soldering carried out using a transport conveyer 60 that conveys the photovoltaic cell holder 30 and a heating space 70. The heating space 70 is a chamber-like space disposed so as to straddle the transport conveyer 60 from above and below, and is a space formed in such a way that a transport surface of the transport conveyer 60 runs through an interior of the heating space 70, and a plurality of heating means 71 is positioned inside the heating space 70.

### Heating and Cooling

The holder 30 transports the photovoltaic cells 10 to the heating space 70 with the transport conveyer 60, with the interconnectors 20 pressed against the electrodes 11 of the photovoltaic cell 10.

Inside the heating space 70, the plurality of heating means 71, such as a plurality of heaters, is arranged both above and below the transport conveyer 60.

The photovoltaic cells 10, having been brought to the heating space 70 by the holder 30, are then heated on both top and bottom surfaces simultaneously by the heating means 71, melting the interconnector solder.

The heated photovoltaic cells 10 are then removed from the heating space 70 by the transport conveyer 60 and cooled either under room temperature conditions or by cooling means such as fans, not shown, thus hardening the solder and completing soldering.

A more detailed description is now given of the photovoltaic cell holder 30 according to the present invention.

### First Embodiment of the Photovoltaic Cell Holder

The photovoltaic cell holder 30 holds the photovoltaic cell 10 and the interconnectors 20 simultaneously, with the interconnectors 20 positioned on the top and bottom surfaces of the photovoltaic cell 10.

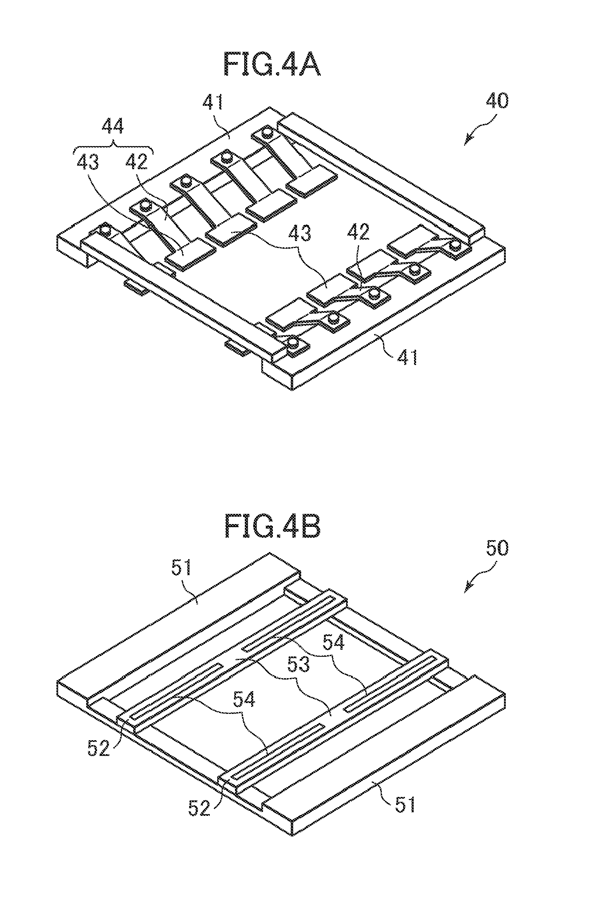

The photovoltaic cell holder 30, as shown in FIGS. 4A and 4B, is comprised of an upper holder 40 that holds the interconnectors 20 against the top surface of the cell 10 and a lower holder 50 that holds the interconnectors 20 against the bottom surface of the cell 10.

The upper holder 40 and the lower holder 50, although not shown, are constructed so as to be positioned and set by positioning pins provided at two locations on a press part 51 and positioning holes provided at two locations on a press part 41.

The interconnectors 20 are set on top of supports 52 of the lower holder 50, the photovoltaic cell 10 is set on top of the interconnectors 20, and the upper holder 40 is positioned from above by the positioning pins and the positioning holes and set on top of the photovoltaic cell 10. In this manner, the photovoltaic cell 10 and the interconnectors 20 are set on the holder 30.

The upper holder 40, as shown in FIG. 4A, is constructed such that a plurality of interconnector upper retainers 44 is arranged on the press part 41. The upper retainers 44 are constructed such that flange parts 43 are mounted on the ends of elastic stick-like press bars 42. The pres bars 42 are bolted to the press part 41. The flange part 43 at the tip of each press bar 42 may be formed as a single integrated structure with the press bar 42 or it may be formed as a separate part and fixedly mounted on the press bar 42.

The press part 41 holds the photovoltaic cell 10 at both side edges of the photovoltaic cell 10.

The press bars 42 and the flange parts 43 mounted on the press bars 42 hold the interconnectors 20.

The lower holder 50, as shown in FIG. 4B, is comprised of the press parts 51 and the supports 52.

The press parts 51 hold the photovoltaic cell 10 at both side edges thereof. The supports 52 support the interconnectors 20.

The supports 52, as shown in FIG. 4B, are bar-shaped, and arranged so as to be parallel to the interconnectors 20. A groove 54 is provided in a surface of each support 52 that contacts the interconnectors 20 (contact surface). Alternatively, this groove may be a slot that penetrates the support 52 or a plurality of round holes that penetrate the support 52.

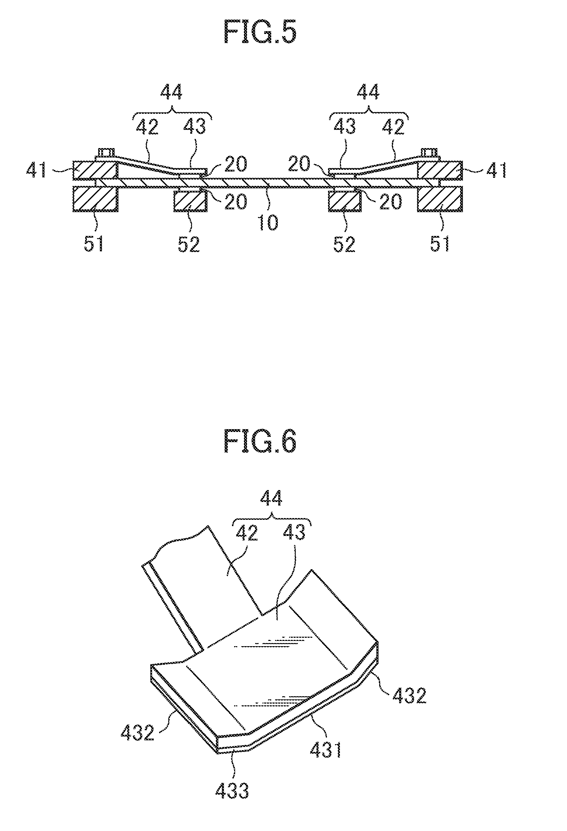

Next, using FIG. 5, a description is given of how the upper holder 40 and the lower holder 50 function.

FIG. 5 is a schematic diagram of the photovoltaic cell holder 30 holding the photovoltaic cell 10 with the interconnectors 20 disposed on top and bottom surfaces of the photovoltaic cell 10.

Both side edges of the photovoltaic cell 10 are sandwiched between the press parts 41 and 51 and the photovoltaic cell 10 is held level. As a result, bending of the cell 10 due to heating and cooling can be prevented.

The interconnectors 20 mounted on the top surface of the cell 10 are pressed and held by the plurality of elastic upper retainers 44. As noted above, the upper retainers 44 are comprised of press bars 42 and flange parts 43 mounted on the tips of the press bars 42. The press bars 42 are stick-shaped and elastic, and therefore the interconnectors 20 held by the flange parts 43 are held tightly against the photovoltaic cell 10 and in that state are heated and cooled, and further, are contacted and held over substantially all areas by the same material, thus conducting heat uniformly to all areas of the interconnectors 20. As a result, uniform welding quality can be obtained.

The flange parts 43 are spaced as shown in FIG. 4A, facilitating the escape of flux gas that is generated during heating of the interconnectors 20 from the bottom surfaces of the flange parts 43 and thus preventing the interconnectors 20 and the flange parts 43 from welding to each other.

The interconnectors 20 mounted on the bottom surface of the cell 10 are held by the supports 52. The supports 52 are bar-shaped, and thus the interconnectors 20 supported by the supports 52 are held tightly against the photovoltaic cell 10 and in that state are heated and cooled, and further, are contacted and held over substantially all areas by the same material, thus conducting heat uniformly to all areas of the interconnectors 20. As a result, uniform welding quality can be obtained.

Grooves 54 are formed in the supports 52 as shown in FIG. 4B, facilitating the escape of the flux gas that is generated during heating of the interconnectors 20 from the contact surfaces 53, thus preventing the interconnectors 20 and the supports 52 from welding together.

It should be noted that, with the holder 30 of the construction described above, interconnectors 20 may be disposed on both the top and bottom sides of the cell 10 as shown in FIG. 5 or the interconnectors 20 may be disposed on one of the two sides of the cell 10.

### Second Embodiment

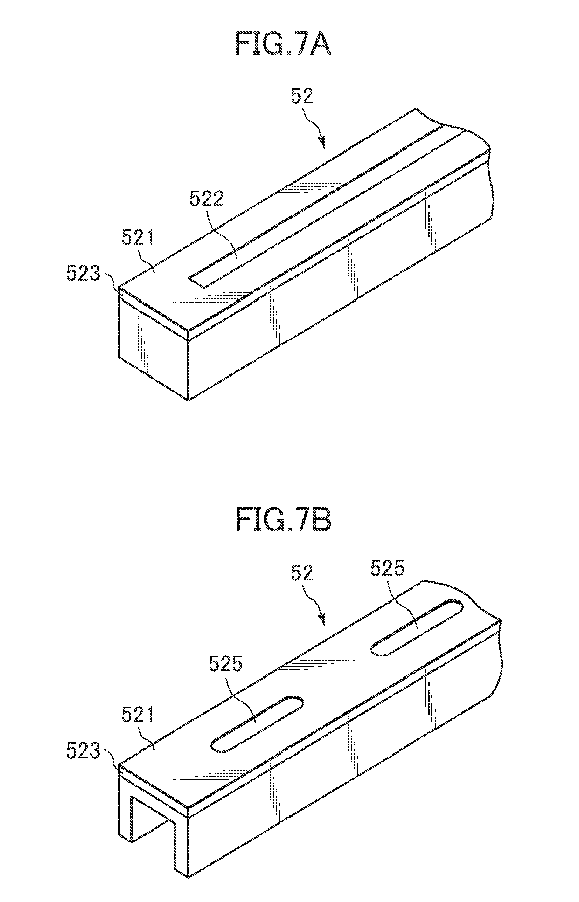

A description is now given of upper retainers 44 and lower supports 52 of a second embodiment of the present invention, using FIG. 6 and FIGS. 7A and 7B.

As shown in FIG. 6, each upper retainer 44 is constructed so that the flange part 43 has tapered portions 432 at both ends in a long direction of the interconnectors 20. Such a construction prevents solder melted by the heating of the interconnectors 20 from adhering to the ends of the flange part 43 and welding the interconnectors 20 and the upper retainer 44 together.

Further, a peel-off layer 433 made of fluoresin or the like may be provided on a contact surface 431 of the flange part 43 that contacts the interconnectors 20. The peel-off layer 433 may be provided by such methods as coating the surface of the side of the flange part 43 that contacts the interconnectors 20 with a fluid composed of fluoresin or the like, or affixing a resin sheet to the surface of the side of the flange part 43 that contacts the interconnectors 20 with an adhesive or the like. Such an arrangement enables the welding together of the interconnectors 20 and the upper retainer 44 to be prevented even more effectively.

Each lower support 52 has a groove 522 provided in a bar-shaped member as shown in FIG. 7A. Further, a peel-off layer 523 made of fluoresin or the like may be provided on a contact surface 521 of the support 52 that contacts the interconnectors 20. The peel-off layer 523 may be provided by the same means as those used to give the flange part 43 the peel-off layer 433. Such an arrangement enables the welding together of the interconnectors 20 and the lower supports 52 to be prevented even more effectively.

Alternatively, instead of a bar-shaped member the lower support 52 may be a U-shaped jig like that shown in FIG. 7B and mounted upside down, with a slot 525 or the usual plurality of round holes that penetrate lower support 52, not shown, to allow the flux gas to escape provided in its top surface. In addition, it is also possible to provide the same peel-off layer 523 shown in FIG. 7A on the contact surface 521 of the lower support 52.

### Third Embodiment

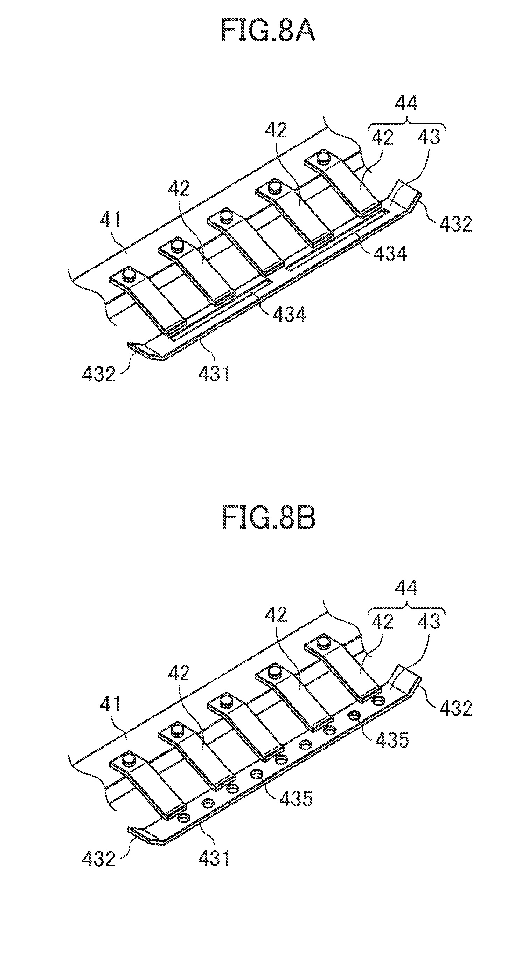

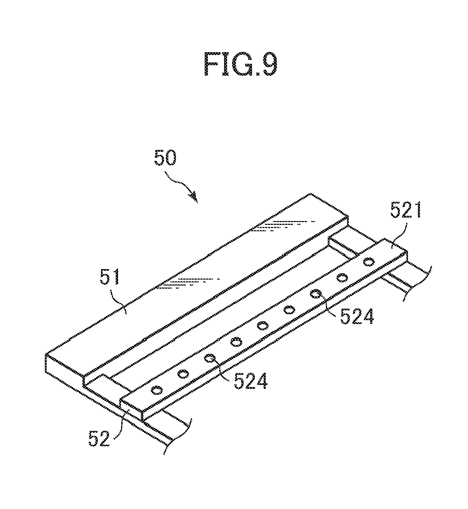

A description is now given of upper retainers 44 and lower supports 52 of a third embodiment of the present invention using FIGS. 8A and 8B and FIG. 9.

The interconnector upper retainer 44 of the upper holder 40, as shown in FIGS. 8A and 8B, are constructed as a single elongated flange part 43 attached_to the tips of a plurality of elastic press bars 42 by brazing or the like using brazing filler metal, which has a higher melting point than that of solder.

The press bars 42 are stick-shaped and elastic, and therefore the interconnectors 20 held by the flange part 43 are held tightly against the photovoltaic cell 10 and in that state are heated and cooled, thus enabling uniform welding quality to be obtained.

The attached flange part 43 may have a slot 434 formed therein as shown in FIG. 8A, or it may have a plurality of holes 435 as shown in FIG. 8B. Further, providing a partial groove in the contact surface 431 of the flange part 43 that contacts the interconnectors 20 as shown in FIGS. 4B and 7A allows the flux gas generated during heating of the interconnectors 20 to escape more easily, thus preventing the welding together of the interconnectors 20 and the flange part 43. A peel-off layer made of fluoresin or the like may also be provided on the contact surface 431 of the flange part 43 that contacts the interconnectors 20. Further, the upper retainer 44 may also be provided with tapered portions 432 at both ends of the flange part 43 as shown in FIG. 6 and described in the second embodiment.

The lower supports 52 of the lower holder 50 may be provided with a plurality of holes 524 that penetrate lower support 52 as shown in FIG. 9, thus facilitating escape of the flux gas generated during heating of the interconnectors 20 from the contact surface 521 and preventing bending of the photovoltaic cell 10.

Further, the lower supports 52, as shown in FIG. 7 and described in the second embodiment, may be provided with a peel-off layer on the contact surfaces 521 of the lower supports 52 that contact the interconnectors 20.

As many apparently widely different embodiments of the present invention can be made without departing from the spirit and scope thereof, it is to be understood that the invention is not limited to the specific embodiments thereof except as defined in the appended claims.

## Claims

1. A photovoltaic cell holder to hold a photovoltaic cell and interconnectors in order to solder the interconnectors to a top surface and a bottom surface of the photovoltaic cell, the photovoltaic cell holder comprising:
an upper holder comprising an upper retainer configured to press the interconnectors against the top surface of the photovoltaic cell, the upper retainer including a plurality of elastic stick-shaped members and one or more flange parts provided at one end of the stick-shaped members; and
a lower holder comprising one or more bar-shaped lower supports configured to support the interconnectors against the bottom surface of the photovoltaic cell, the lower supports extending parallel to the interconnectors, a surface of each lower support that contacts the interconnectors having one of a groove and a hole formed therein.

2. The photovoltaic cell holder according to claim 1, wherein a tapered portion is provided at each of both ends of the flange part of the upper retainer in a long direction of the interconnectors.

3. The photovoltaic cell holder according to claim 1, wherein the flange part of the upper retainer is attached to a plurality of the stick-shaped members and has one of a groove and a hole formed therein.

4. The photovoltaic cell holder according to claims 1, wherein a peel-off layer is provided on one of a contact portion of the upper retainer that contacts the interconnectors and a contact portion of the lower support that contacts the interconnectors.
